# EUROPEAN PATENT APPLICATION

(11) **EP 4 553 201 A1**
(43) Date of publication of application: **14.05.2025**
(21) Application number: 24812346.5
(22) Date of filing: 24.05.2024
(51) Int. Cl.: C30B 29/36, C30B 23/00, H01L 21/04

(54) **HIGH-QUALITY SIC CRYSTAL, CRYSTAL BAR, SUBSTRATE, AND SEMICONDUCTOR DEVICE**

(30) Priority: 28.09.2023 CN 202311265574; 03.11.2023 CN 202311464892; 13.05.2024 CN 202410586417
(71) Applicant: SICC CO., LTD., Jinan, Shandong 250118 (CN)
(72) Inventor: GAO, Chao, Jinan, Shandong 250118 (CN); GAO, Yuhan, Jinan, Shandong 250118 (CN); YANG, Xiaoli, Jinan, Shandong 250118 (CN); SHI, Zhiqiang, Jinan, Shandong 250118 (CN); PENG, Hongyu, Jinan, Shandong 250118 (CN); PAN, Yani, Jinan, Shandong 250118 (CN); FANG, Shuai, Jinan, Shandong 250118 (CN); NING, Xiuxiu, Jinan, Shandong 250118 (CN)
(74) Representative: Huang, Liwei
(86) International application number: PCT/CN2024/095258
(87) International publication number: WO 2025/066207

(57) **Abstract**

The present invention provides a high-quality SiC crystal, a crystal bar, a substrate and a semiconductor device, and relates to the technical field of silicon carbide wafers. The SiC crystal contains a facet region and a non-facet region; and the facet region is located on an outer circumference of the SiC crystal, a distance between an edge of the facet region away from the outer circumference and the outer circumference does not exceed 3% of a diameter of the SiC crystal, and the SiC crystal is obtained by adopting a PVT method through direct growth without subsequent processing. In a subsequent processing process of the crystal, the facet region is eliminated, and the situation that the entire crystal bar and a wafer and substrate processed accordingly have no facet region is implemented with a low cutting loss rate. It is ensured that a device end has higher yield, performance and reliability.

## Description

The present invention claims priority to Chinese Patent Application No. 202311265574.7, filed with CNIPA on September 28, 2023 and entitled "High-quality Silicon Carbide Substrate and Semiconductor Device", and Chinese Patent Application No. 202311464892.6, filed with CNIPA on November 3, 2023 and entitled "SiC Crystal with Facets in Edge Area and Wafer thereof and Semiconductor Device", the entire contents of which are incorporated herein by reference.

### TECHNICAL FIELD

The present invention relates to the technical field of silicon carbide wafers, in particular to a high-quality SiC crystal, a crystal bar, a substrate and a semiconductor device.

### BACKGROUND

At present, silicon carbide crystals face two major problems: 1, a quality problem, affecting the yield, performance and reliability of a device end of silicon carbide; and 2, a cost problem, affecting applications of the silicon carbide at a terminal. The material and device yield loss caused by the material quality is also a primary cause causing high cost and difficult applications of the silicon carbide crystals at present.

The quality problem of the silicon carbide crystals includes two types: one is the material quality and yield problem caused by a defect problem, which is an explicit quality problem; and the other is the material yield and device performance reliability problem caused by a consistency problem.

At present, since a growth character face is an inherent attribute of a SiC crystal prepared by a sublimation method, these growth character faces will exist on the SiC crystal and a substrate prepared by a conventional physical vapor transport method (PVT for short). In the field, the growth character face is commonly known as a "facet", "growth facet", "character growth face" or the like, its corresponding English is "facet", and the growth character face in the present invention does not refer to a growth interface.

Improving the quality and reducing the cost are objectives of the sustainable development of silicon carbide crystal materials. Especially at a current stage of the silicon carbide industry rapidly stepping into large-scale production and application, the performance stability, consistency and reliability of the silicon carbide materials play a crucial role in the industrial development.

### SUMMARY

In order to solve the above problem, a first aspect of the present invention provides a SiC crystal with facets in edge area, and the SiC crystal contains a facet region and a non-facet region; and the facet region is located on an outer circumference of the SiC crystal, a distance between an edge of the facet region away from the outer circumference and the outer circumference does not exceed 3% of a diameter of the SiC crystal, and the SiC crystal is obtained by adopting a PVT method through direct growth without subsequent processing.

The outer circumference refers to an edge position where the crystal grows transversely, or is called the edge position of the crystal. The edge of the facet region away from the outer circumference refers to an end in the facet region close to a center of the silicon carbide crystal.

In some embodiments, a maximum sectional area of the facet region occupies 10% or below of a cross sectional area of the crystal in a diameter direction; and/or a volume of the facet region occupies 2% or below of a volume of the entire crystal. For example, the facet region may be located at an edge of an inclined upper corner or an inclined lower corner of the crystal.

In some embodiments, the maximum sectional area of the facet region occupies 5% or below of the cross sectional area of the crystal in the diameter direction; and/or the volume of the facet region occupies 0.6% or below of the volume of the entire crystal. An overall shape of the facet region may be triangular, conical, spherical, ellipsoidal, or rhombic. However, the present invention is not limited to this, and the facet region may be in an irregular shape.

In some embodiments, an in-plane resistivity difference containing the facet region is 5 times or above an in-plane resistivity difference of the non-facet region; and/or a transmittance difference of the facet region is 5 times or above a transmittance difference of the non-facet region; and/or a TDV of the facet region is 6 times or above a TDV of the non-facet region.

In some embodiments, the in-plane resistivity difference containing the facet region is 8 times or above the in-plane resistivity difference of the non-facet region; and/or the transmittance difference of the facet region is 14 times or above the transmittance difference of the non-facet region; and/the TDV of the facet region is 10 times or above the TDV of the non-facet region.

In some embodiments, a cross section of the facet region in the diameter direction is in an ellipsoidal shape, a meniscate shape, or a circular shape. However, the present invention is not limited to this, and the cross section of the facet region in the diameter direction may be in an irregular shape.

A second aspect of the present invention provides a facet-free silicon carbide crystal bar, and the facet-free silicon carbide crystal bar is obtained by removing the facet region from a SiC crystal with facets in edge area.

A third aspect of the present invention provides a SiC wafer, the SiC wafer is obtained by removing the facet region from the SiC crystal with facets in edge area so as to obtain a facet-free silicon carbide crystal bar and then cutting the facet-free silicon carbide crystal bar, and the whole area range of the SiC wafer does not contain any one or two or above of the following: a facet, a highly-doped area, a defect aggregation area.

In some embodiments, an in-plane resistivity difference of the SiC wafer is less than or equal to 2 mΩ•cm; and/or a transmittance difference is less than or equal to 3%; and/or the TDV is less than 200 cm⁻².

In some embodiments, the in-plane resistivity difference of the SiC wafer is less than or equal to 1 mΩ•cm; and/or the transmittance difference is less than or equal to 2%; and/or the TDV is less than 100 cm⁻².

In some embodiments, the SiC wafer is a silicon carbide wafer with any thickness. For example, the thickness of the SiC wafer is not lower than 200 µm; or the thickness of the silicon carbide wafer is not lower than 300 µm; or the thickness of the silicon carbide wafer is not lower than 400 µm.

In some embodiments, the SiC wafer may be N₂ doped or co-doped with any other elements. Optionally, nitrogen may be co-doped with any one or two or more elements in P, As, Ge, Sn, B and Al, and the prepared silicon carbide wafer is of a conductive type.

In the present invention, a silicon carbide substrate is obtained by removing the facet region from the SiC crystal with facets in edge area to obtain the facet-free silicon carbide crystal bar, then cutting the facet-free silicon carbide crystal bar to obtain a stripped sheet, and thinning, polishing and cleaning sequentially on the stripped sheet, and in the present invention, the silicon carbide wafer is obtained through direct cutting.

A fourth aspect of the present invention provides a high-quality silicon carbide substrate. The high-quality silicon carbide substrate is obtained by removing the facet region from a SiC crystal with facets in edge area, and the silicon carbide substrate is of a conductive type, and the whole area does not contain any one or two or more of the following: a growth character face, a highly-doped area, a defect aggregation area; and the silicon carbide substrate is prepared by adopting a PVT method.

The growth character face is an inherent attribute of the SiC crystal prepared by the PVT method, the high-quality silicon carbide substrate in the present invention may change a movement tendency of the growth character face during growth by the PVT method, so that the growth character face moves to the edge of the crystal to be fixed within a range 5 mm from the edge of the crystal, the edge is cut when the crystal is actually utilized, and thus, after the crystal is cut, ground, polished and the like, the silicon carbide substrate not containing the growth character face may be obtained.

In an original substrate, since the existence of the growth character face will make defects be dense in the area, and in an element doping process, elements will also be induced to aggregate and increase at the growth character face, thus, uneven doping is caused and a resistivity is also higher at the growth character face compared with other areas, the overall transmitting evenness of the substrate is poor, and the above limits the scale use of the silicon carbide substrate.

In the present invention, the high-quality silicon carbide substrate has no growth character face, the substrate is integrally evenly distributed both radially and axially, so that generation and aggregation of the defects may be choked fundamentally, elements are also prevented from being aggregated in the doping process, even doping of the elements is implemented, so that the doping evenness, the resistivity evenness and the transmittance evenness of the substrate are improved, and devices produced from the silicon carbide substrate not only have good self-performance, but also have good consistency in mass production, facilitating industrialization promotion and use.

In some embodiments, when the silicon carbide substrate is an N-type element doping and an N-type element doping concentration is greater than 1e¹⁸cm⁻³, the whole area of the high-quality silicon carbide substrate meets the following condition:
a, an in-plane resistivity difference is less than or equal to 2.0 mΩ•cm;
b, a transmittance difference is less than or equal to 3%.

For example, the in-plane resistivity difference is less than or equal to 1.0 mΩ•cm; or the in-plane resistivity difference is less than or equal to 0.9 mΩ•cm; or the in-plane resistivity difference is less than or equal to 0.7 mΩ•cm. The in-plane resistivity refers to a resistivity of any in-plane test position of the silicon carbide substrate.

In some embodiments, the doping concentration is 2e¹⁸-7e¹⁸cm⁻³, and the in-plane resistivity difference is 0.62-0.86 mΩ•cm.

In some embodiments, the transmittance difference is less than or equal to 2%; or the transmittance difference is less than or equal to 1%; or the transmittance difference is less than or equal to 0.8%.

In some embodiments, the transmittance difference ranges from 0.5% to 1.6%. Optionally, the transmittance difference ranges from 0.5% to 1%. In some embodiments, the substrate is the silicon carbide substrate with any thickness. For example, the thickness of the silicon carbide substrate is not lower than 200 µm; or the thickness of the silicon carbide substrate is not lower than 300 µm; or the thickness of the silicon carbide substrate is not lower than 400 µm.

For example, the N-type element is N₂ doped or co-doped with any other elements. The in-plane resistivity difference is 0.62-0.86 mΩ•cm. And the transmittance difference ranges from 0.5% to 1.6%. Optionally, nitrogen may be co-doped with any one or two or more elements in P, As, Ge, Sn, B and Al, and the prepared silicon carbide wafer is still of a conductive type.

The doping concentration of the above N-type element is greater than 1e18cm⁻³, and belongs to medium-high nitrogen-doped. For those skilled in the art, the higher the doping concentration is, the more easily the condition of uneven doping exists, and thus, the larger the in-plane resistivity difference is. According to the present invention, in the process of controlling the movement tendency of the growth character face, the growth character face is fixed to the edge of the crystal, thus, the doping evenness may be improved in the doping process, and the transmittance of the substrate is more even.

The transmittance is related to the doping concentration and evenness in the crystal, and the transmittance difference of the silicon carbide substrate of the present invention is less than or equal to 3%, and may represent the even transmittance of the silicon carbide substrate, facilitating improving the photolithography technique quality of a downstream device end, and then improving the device performance.

In some embodiments, a TDV of the silicon carbide substrate is less than 200 cm⁻². Optionally, the TDV of the silicon carbide substrate is less than 100 cm⁻². Optionally, the TDV of the silicon carbide substrate is less than 10 cm⁻². The total density variation (TDV for short) is defined as follows: a plurality of grids with specific areas are divided in the substrate, for example, n grids with the areas of 1 mm x 1 mm, 2 mm x 2 mm, 5 mm x 5 mm and 10 mm x 10 mm, and densities of an edge dislocation (TED for short) or a helical dislocation (TSD for short) in the grids are d1, d2, d3, ... dn. TDV is a difference dmax-dmin between a maximum density of the TED/TSD and a minimum density of the TED/TSD.

In the silicon carbide substrate of the present invention, since the growth character face is eliminated, TED and TSD are distributed more evenly, thus, a value of TDV is low, representing that the overall dislocation distribution of the substrate is relatively even, and the problems of low overall defect density but high local density in the substrate at present are eliminated.

When power electronic devices are prepared using the above substrate, due to the characteristics of low in-plane resistivity difference and low transmittance difference, it can be ensured that the devices have excellent electrical performance and reliability in the process of device production.

In some embodiments, a size of the silicon carbide wafer or the silicon carbide substrate may be 4 inches, 6 inches, 8 inches, 10 inches, or 12 inches.

A fifth aspect of the present invention provides a semiconductor device, and the semiconductor device contains the above SiC wafer or high-quality silicon carbide substrate.

In some embodiments, as the facet is an inherent attribute existing when the SiC crystal is prepared by a sublimation method, such facet region exits on both the SiC crystal and wafer prepared by a conventional physical vapor transportation method. In order to fix the facet to the edge position of the crystal and remove the facet in the subsequent crystal machining process so that no facet exists on the whole crystal bar as well as the wafer and the substrate obtained after subsequent machining, a machining manner of the SiC crystal with the facet at the edge in the present invention includes a crystal stable growth stage. Technical growth conditions of the crystal stable growth stage include the following steps:
S1: a defining edge exists close to a growth edge of SIC crystal, a distance between the defining edge and the growth edge of the SIC crystal is less than or equal to 5 mm, and a negative radial temperature gradient from -5°C/mm to -0.1°C/mm is set within a range of the defining edge and the growth edge of the SIC crystal; and a continuous positive temperature gradient is set from the defining edge to a center of the SIC crystal, and a continuous positive temperature gradient value is less than or equal 3°C/cm; and
S2: a seed crystal greater than a diameter of a target growth silicon carbide crystal is configured for crystal growth, a diameter of the seed crystal is at least 5 mm or above greater than the diameter of the target growth silicon carbide crystal and the high-quality silicon carbide substrate, and the high-quality silicon carbide substrate is obtained by processing the target growth silicon carbide crystal.

In some embodiments, the distance between the defining edge and the growth edge of the crystal is less than or equal to 3 mm.

In some embodiments, in step S1: 5 mm from the growth edge of the crystal is taken as a boundary, the negative radial temperature gradient from -5°C/mm to -0.1°C/mm is set within the range less than 5 mm at the growth edge of the crystal; and a continuous positive temperature gradient is set within a range greater than 5 mm at the growth edge of the crystal, and a continuous positive temperature gradient value is less than or equal 3°C/cm.

In some embodiments, in step S1, the negative radial temperature gradient is set within the range less than 5 mm at the growth edge of the crystal from -3°C/mm to -1°C/mm.

The radial temperature gradient is calculated as a proportion of a difference (T2-T1) between a temperature T1 at a point near a center of a wafer body and a temperature T2 at a point far from the center of the wafer body to a distance d of the two points in a direction by taking the center of the wafer body as an origin and radiating outwards in the radial direction, and the positive (forward) temperature gradient ΔT=(T2-T1)/d; otherwise, it is the negative temperature gradient ΔT=(T1-T2)/d.

The preparation method adopted by the present invention this time is that under setting of S1, the growth character face may be driven to move to the edge of the crystal, and fixed within the range of 5 mm from the edge of the crystal, so as to obtain the high-quality silicon carbide substrate. However, those skilled in the art may understand that the movement tendency of the growth character face may further be controlled in other manners, so that the silicon carbide substrate of the present invention is obtained. The present invention merely illustrates the preparation method of the high-quality silicon carbide substrate obtained this time, and other control methods controlling the tendency of the growth character face are not within a study range of the present invention.

The crystal growth radial temperature gradient in step S1 may be set through industrial conventional technical means, for example, integral adjustment is performed by adjusting parameters such as temperature or pressure or insulating layer material thickness of a growth chamber. Discontinuous temperature gradient setting may be structurally modified in the growth chamber of the crystal, the temperature distribution of a crystal growth interface is optimized, so that controllable adjustment of the temperature gradient is implemented, for example, a material with a heat conductivity lower than that of a central area is placed at an edge of the growth chamber of the crystal, so as to reduce edge heat loss, and thus, the temperature distribution jumping at the crystal growth interface is implemented; otherwise, according to solutions, for example, a material with a higher heat conductivity is placed at the growth edge of the crystal or a thickness of an edge insulting layer is reduced, the reversed temperature gradient distribution may be set; and in addition, different thermal field structures or novel materials may further be arranged in the growth chamber to adjust the temperature distribution, for example, a material coated with a TaC coating with a high reflectance is set on a graphite annulus at the growth edge of the crystal, so that heat radiations in the growth chamber are concentrated to the growth edge of the crystal, and thus the temperature gradient jumping is implemented. Through the above industrial universal technical means, solution configuration may be performed according to actual needs, so as to achieve an objective of adjusting the temperature gradient in the growth chamber of the crystal.

In some embodiments, at the crystal stable growth stage, a temperature in the growth chamber rises to 2200°C or above at a rate of 10-50°C/min, and meanwhile, a pressure in the growth chamber is reduced to 1-100 mbar, and then is kept for 50 h or above under setting of steps S1 and S2 for crystal growth.

In some embodiments, at the crystal stable growth stage, the temperature in the growth chamber rises to 2200°C or above at a rate of 10-30°C/min, and meanwhile, the pressure is reduced to 5-50 mbar, and then is kept for 50 h or above under setting of steps S1 and S2 for crystal growth.

In the present invention, the silicon carbide crystal is prepared by adopting the PVT method, crystal growth adopts isostatic pressing formed graphite as a raw material of the growth chamber (crucible), and SiC powder is taken as a raw material for crystal growth. In order to ensure the excellent and stable electrical property of the silicon carbide, in some embodiments, the present invention adopts silicon carbide compound powder with a certain purity, a total impurity content of the silicon carbide powder is less than or equal to 1E¹⁹cm⁻³; and in some embodiments, the total impurity content of the silicon carbide powder is less than or equal to 1E¹⁷cm⁻³.

In the present invention, when the silicon carbide crystal grows, after the SiC powder is loaded into the graphite crucible chamber and a SiC seed crystal is placed at the top of the growth chamber, the crucible is sealed, and the crucible is placed in a thermal insulation material prepared by a graphite soft felt or hard felt to be wrapped, and then moved to the growth equipment chamber of the crystal for crystal growth.

In some embodiments, before the crystal stable growth stage, a crystal nucleation stage is further included, and growth technological conditions of the crystal nucleation stage include the following steps:
after the growth chamber of the crystal is sealed, the growth chamber is vacuumized to 10⁻³ Pa or below, inert gases starts to be introduced after a vacuum stage is stabilized for a period of time, so that the pressure in the growth chamber gradually rises to 100-1000 mbar and then is constant, and meanwhile, nitrogen is introduced into the chamber at 1 ml/min to 100 ml/min.

In some embodiments, the pressure in the growth chamber rises at the crystal nucleation stage, meanwhile, the temperature in the growth chamber gradually rises from 1600°C to 2100°C and then is constant, and is kept for 5-50 h at the constant temperature and isopiestic pressure and then for the crystal stable growth stage.

In some embodiments, the temperature in the growth chamber is constant as 1800-2100°C at the crystal nucleation stage, and the pressure in the growth chamber is constant at 300-800 mbar, and is kept for 30-50 h at the constant temperature and isopiestic pressure and then for the crystal stable growth stage.

At the crystal nucleation stage, silicon carbide powder is sublimated to form a crystal nucleus, at the subsequent crystal stable growth stage, the silicon carbide powder may be fully sublimated and transported to the seed crystal for stable growth, the silicon carbide crystal is finally obtained. Since a diameter of the seed crystal in step S2 is at least 5 mm or above greater than that of the target crystal and substrate, the prepared SiC crystal has edge processing allowances, and the high-quality silicon carbide crystal may be obtained by cutting the edge. For example, the diameter of the seed crystal is 160 mm, the diameter of the substrate is 150 mm or the diameter of the seed crystal is 210 mm, the diameter of the substrate is 200 mm, smooth preparation of the large-sized silicon carbide substrate may be ensured, and the quality of the prepared silicon carbide substrate may further be improved.

Compared with the prior art, the present invention at least has one of the following beneficial effects:
(1) in the present invention, the SiC crystal with facets in edge area directly fixes the facet region to the edge of the crystal in the PVT growth process, the distance between the edge of the facet region away from the outer circumference and the outer circumference does not exceed 3% of the diameter of the SiC crystal, the facet region is eliminated in the subsequent processing process of the crystal, and the situation that the entire crystal bar and the wafer and substrate processed accordingly have no facet region is implemented with a low cutting loss rate.
(2) The SiC wafer of the present invention has high evenness, for example, the electrical evenness (for example, the electrical resistivity evenness), the transmittance evenness and the defect distribution evenness. In addition, the silicon carbide wafer of the present invention has no macroscopic facet region.
(3) The silicon carbide substrate of the present invention has high electrical evenness (for example, the electrical resistivity), high transmittance evenness and high defect distribution evenness, when the substrate is cut for preparing a semiconductor device, an active area utilization rate may be improved, compared with other substrates with the equal area, the prepared semiconductor device not only has good performance, but also has more quantities, and production costs of the semiconductor device may be reduced.
(4) In the present invention, the TDV of the silicon carbide substrate is less than 200 cm⁻² within the total area range, the problems of low integral defect density, but high local density existing in the substrate at present are eliminated, defects such as dislocation and stacking fault hardly exist, and thus, the silicon carbide substrate is better applied to large-scale promotion and use.
(5) The silicon carbide substrate of the present invention has no macroscopic growth character face, the resistivity difference within the total area range is less than or equal to 2.0 mΩ•cm, the transmittance difference is less than or equal to 3%, representing that the silicon carbide substrate has high evenness, and the semiconductor device prepared by using the silicon carbide substrate has higher yield, performance and reliability.

### BRIEF DESCRIPTION OF THE DRAWINGS

The above and/or appended aspects and advantages of the present invention will become apparent and easy to understand by the description of embodiment in conjunction with accompanying drawings.
FIG. 1 shows an embodiment of a schematic structural diagram of a silicon carbide substrate containing a macroscopic facet of the present invention;
FIG. 2 shows an embodiment of a schematic diagram of a facet growth process of the present invention;
FIG. 3 shows an embodiment of a schematic structural diagram of a SiC crystal with facets in edge area of the present invention;
FIG. 4 shows a diagram of a test method of a transmittance;
FIG. 5 shows a mapping diagram of a resistivity of a silicon carbide substrate of embodiment 1 of the present invention;
FIG. 6 shows a mapping diagram of a resistivity of a silicon carbide substrate of embodiment 2 of the present invention;
FIG. 7 shows a mapping diagram of a resistivity of a silicon carbide substrate of embodiment 3 of the present invention;
FIG. 8 shows a mapping diagram of a resistivity of a silicon carbide substrate of embodiment 4 of the present invention;
FIG. 9 shows a mapping diagram of a resistivity of a silicon carbide substrate of comparative example 1 of the present invention;
FIG. 10 shows a mapping diagram of a resistivity of a silicon carbide substrate of comparative example 1 of the present invention;
FIG. 11 shows a mapping diagram of a resistivity of a silicon carbide substrate of comparative example 1 of the present invention;
FIG. 12 shows a mapping diagram of a resistivity of a silicon carbide substrate of comparative example 1 of the present invention;
FIG. 13 shows a comparison diagram of transmittances of a silicon carbide substrate of embodiment 2 and a silicon carbide substrate of comparative example 1 of the present invention;
FIG. 14 shows a variation curve diagram of a transmittance of a silicon carbide substrate of embodiment 3 of the present invention; and
FIG. 15 shows a schematic structural diagram of a silicon carbide substrate without a growth character face of the present invention.

### DETAILED DESCRIPTION OF THE EMBODIMENTS

In order to understand the above objectives, features and advantages of the present invention more clearly, the present invention is further described in detail in conjunction with accompanying drawings and specific embodiments below. It needs to be noted that embodiments of the present invention and features in the embodiments may be combined with each other when there is no confliction.

Many specific details are explained in the following description for fully understanding the present invention, however, the present invention may further adopt other manners different from the manners described here for implementing, and thus, the scope of protection of the present invention is not limited by specific embodiments disclosed below.

At present, since a current silicon carbide substrate or silicon carbide wafer has a growth character face, a resistivity at the growth character face is too low, causing that resistivity distributions are uneven, transmittance distributions are uneven and carrier concentration change rates are uneven within a total area range of the silicon carbide substrate, then defects such as a dislocation and a stacking fault generated in this area may be caused, and problems such as stacking fault extension generated in the subsequent use process of devices may also be caused. In order to solve the above problems, the present invention provides a high-quality silicon carbide substrate, the silicon carbide substrate has no macroscopic growth character face within the total area range, and the silicon carbide substrate has high evenness in resistivity, doping concentration, transmittance and carrier concentration within the total area range.

In the process of preparing a silicon carbide crystal in the following embodiments 1 to 5, the growth character face may be fixed at an edge of the silicon carbide crystal, and with processing of the edge of the crystal, a silicon carbide substrate or a silicon carbide wafer without the growth character face is obtained. Since disappearing of the growth character face, an inherent structure attribute, the quantity of self-defects of the silicon carbide substrate or the silicon carbide wafer is reduced, and an aggregation may not be generated; and meanwhile, element aggregations in doping may further be avoided, that is, the existence of a highly-doped area is avoided, such that the doping evenness, the transmittance evenness and the resistivity evenness of the silicon carbide substrate or the silicon carbide wafer without the growth character face are all improved.

### Embodiment 1

The embodiment relates to a preparation method of a 6-inch high-quality silicon carbide substrate, specifically including the following steps:

### (1) crystal nucleation stage

Silicon carbide powder and a seed crystal are loaded into a crucible, then a growth chamber is sealed, the growth chamber is vacuumized to 10⁻³ Pa or below through a mechanical pump and a vacuum pump, inert gases start to be introduced after the silicon carbide powder and the seed crystal are stabilized at a vacuum stage for a period of time, so that a pressure in the growth chamber gradually rises to 100 mbar, and meanwhile, nitrogen is introduced into the chamber with 100 ml/min. The pressure rises in the growth chamber at the crystal nucleation stage, and meanwhile, a furnace temperature gradually rises from a room temperature to 1600°C and is kept for 50 h through power setting.

### (2) crystal stable growth stage

After the crystal nucleation stage ends, a temperature rises to 2200°C at a rate of 20°C/min, and meanwhile, the pressure in the growth chamber is reduced to 50 mbar and kept for 50 h by regulating and controlling a pressure controller. Specifically:
S1: 5 mm from a growth edge of the crystal is taken as a boundary, a negative radial temperature gradient is set within a range less than 5 mm from the growth edge of the crystal to be -0.1°C/mm, a continuous positive temperature gradient is set within a range greater than 5 mm from the growth edge of the crystal, and the continuous positive temperature gradient is 1°C/cm; and
S2: a seed crystal greater than a diameter of a target growth silicon carbide crystal is used for crystal growth, and a diameter of the seed crystal is 5 mm greater than the diameter of the target crystal. The target crystal obtained through growth is cut, ground, polished and the like to obtain a target silicon carbide substrate.

### Embodiment 2

The embodiment relates to a preparation method of a 6-inch high-quality silicon carbide substrate, specifically including the following steps:

### (1) crystal nucleation stage

Silicon carbide powder and a seed crystal are loaded into a crucible, then a growth chamber is sealed, the growth chamber is vacuumized to 10⁻³ Pa or below through a mechanical pump and a vacuum pump, inert gases start to be introduced after the silicon carbide powder and the seed crystal are stabilized at a vacuum stage for a period of time, so that a pressure in the growth chamber gradually rises to 300 mbar, and meanwhile, nitrogen is introduced into the chamber with 400 ml/min. The pressure rises in the growth chamber at the crystal nucleation stage, and meanwhile, a furnace temperature gradually rises from a room temperature to 1800°C and is kept for 30h through power setting.

### (2) crystal stable growth stage

After the crystal nucleation stage ends, a temperature rises to 2400°C at a rate of 30°C/min, and meanwhile, the pressure in the growth chamber is reduced to 10 mbar and kept for 70 h by regulating and controlling a pressure controller. Specifically:
S1: 4.5 mm from a growth edge of the crystal is taken as a boundary, a negative radial temperature gradient is set within a range less than 4.5 mm from the growth edge of the crystal to be -5°C/mm, a continuous positive temperature gradient is set within a range greater than 4.5 mm from the growth edge of the crystal, and the continuous positive temperature gradient is 1°C/cm; and
S2: a seed crystal greater than a diameter of a target growth silicon carbide crystal is used for crystal growth, and a diameter of the seed crystal is 6 mm greater than the diameter of the target crystal. The target crystal obtained through growth is cut, ground, polished and the like to obtain a target silicon carbide substrate.

### Embodiment 3

The embodiment relates to a preparation method of a 6-inch high-quality silicon carbide substrate, specifically including the following steps:

### (1) crystal nucleation stage

Silicon carbide powder and a seed crystal are loaded into a crucible, then a growth chamber is sealed, the growth chamber is vacuumized to 10⁻³ Pa or below through a mechanical pump and a vacuum pump, inert gases start to be introduced after the silicon carbide powder and the seed crystal are stabilized at a vacuum stage for a period of time, so that a pressure in the growth chamber gradually rises to 500 mbar, and meanwhile, nitrogen is introduced into the chamber with 400 ml/min. The pressure rises in the growth chamber at the crystal nucleation stage, and meanwhile, a furnace temperature gradually rises from a room temperature to 2100°C and is kept for 50 h through power setting.

### (2) crystal stable growth stage

After the crystal nucleation stage ends, a temperature rises to 2500°C at a rate of 10°C/min, and meanwhile, the pressure in the growth chamber is reduced to 20 mbar and kept for 70 h by regulating and controlling a pressure controller. Specifically:
S1: 3.5 mm from a growth edge of the crystal is taken as a boundary, a negative radial temperature gradient is set within a range less than 3.5 mm from the growth edge of the crystal to be -3°C/mm, a continuous positive temperature gradient is set within a range greater than 3.5 mm from the growth edge of the crystal, and the continuous positive temperature gradient is 3°C/cm; and
S2: a seed crystal greater than a diameter of a target growth silicon carbide crystal is used for crystal growth, and a diameter of the seed crystal is 6 mm greater than the diameter of the target crystal. The target crystal obtained through growth is cut, ground, polished and the like to obtain a target silicon carbide substrate.

### Embodiment 4

The embodiment relates to a preparation method of a 6-inch high-quality silicon carbide substrate, specifically including the following steps:

### (1) crystal nucleation stage

Silicon carbide powder and a seed crystal are loaded into a crucible, then a growth chamber is sealed, the growth chamber is vacuumized to 10⁻³ Pa or below through a mechanical pump and a vacuum pump, inert gases starts to be introduced after the silicon carbide powder and the seed crystal are stabilized at a vacuum stage for a period of time, so that a pressure in the growth chamber gradually rises to 300 mbar, and meanwhile, nitrogen is introduced into the chamber with 300 ml/min and doped with P. The pressure rises in the growth chamber at the crystal nucleation stage, and meanwhile, a furnace temperature gradually rises from a room temperature to 2000°C and is kept for 50 h through power setting.

### (2) crystal stable growth stage

After the crystal nucleation stage ends, a temperature rises to 2600°C at a rate of 40°C/min, and meanwhile, the pressure in the growth chamber is reduced to 20 mbar and kept for 80 h by regulating and controlling a pressure controller. Specifically:
S1: 3 mm from a growth edge of the crystal is taken as a boundary, a negative radial temperature gradient is set within a range less than 3 mm from the growth edge of the crystal to be -4°C/mm, a continuous positive temperature gradient is set within a range greater than 3 mm from the growth edge of the crystal, and the continuous positive temperature gradient is 0.5°C/cm; and
S2: a seed crystal greater than a diameter of a target growth silicon carbide crystal is used for crystal growth, and a diameter of the seed crystal is 8 mm greater than the diameter of the target crystal. The target crystal obtained through growth is cut, ground, polished and the like to obtain a target silicon carbide substrate.

### Embodiment 5

A difference between the embodiment and embodiment 2 is that in step S1, a negative radial temperature gradient is set within a range less than 4.5 mm from a growth edge of a crystal to be -1°C/mm, an 8-inch silicon carbide substrate is prepared in the embodiment, and the rest of steps are the same as embodiment 2.

### Comparative example 1

A difference between the comparative example and embodiment 2 is that in step S1, a continuous positive temperature gradient is set from a center to an edge of a crystal, the continuous positive temperature gradient is 3°C/cm, and the rest of steps are the same as embodiment 2.

### Comparative example 2

A difference between the comparative example and embodiment 2 is that in step S1, a negative radial temperature gradient is set within a range less than 4.5 mm from a growth edge of a crystal to be -6°C/mm, an 8-inch silicon carbide substrate is prepared in the embodiment, and the rest of steps are the same as embodiment 2.

### Experimental embodiment 1

According to a SiC crystal with facets in edge area prepared through the above method, a position test of a facet region in the crystal refers to Table 1. A volume of the facet region may be calculated by adopting a calculus or a modeling manner.

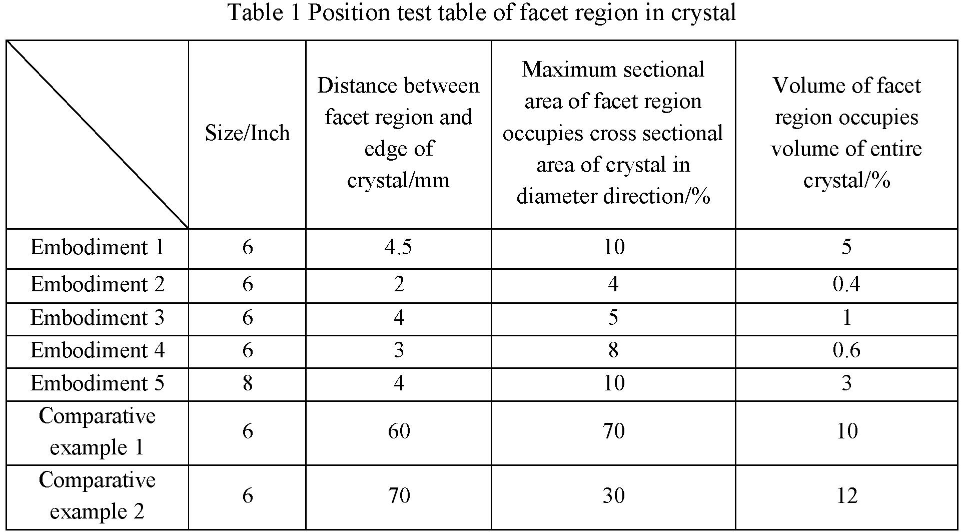

Referring to Table 1, it may be seen that the distance between the facet region and the edge of the crystal of the SiC crystal in the present invention is controlled within a range of 5 mm. According to the present invention, in the PVT production process, the facet region is directly controlled on an outer circumference from the crystal, the facet is driven to move to an outer area of a crystal target diameter, and the facet region may be eliminated with a low cutting loss rate in the subsequent crystal processing process, so as to obtain a SiC crystal with less defects. The facet regions in comparative example 1 and comparative example 2 are at middle positions, and located within the range of crystal target diameter, causing that devices obtained through the subsequent processing have low yield, performance and reliability.

The SiC crystal with facets in edge area obtained by the embodiment is processed to eliminate the facet region, and then is directly cut to obtain a SiC wafer. comparative example 1 is cut to form a silicon carbide wafer, and a performance test of the SiC wafer refers to Table 2.

An in-plane resistivity difference is "an in-plane resistivity maximum - an in-plane resistivity minimum"; and a transmittance difference is "a transmittance maximum - a transmittance minimum".

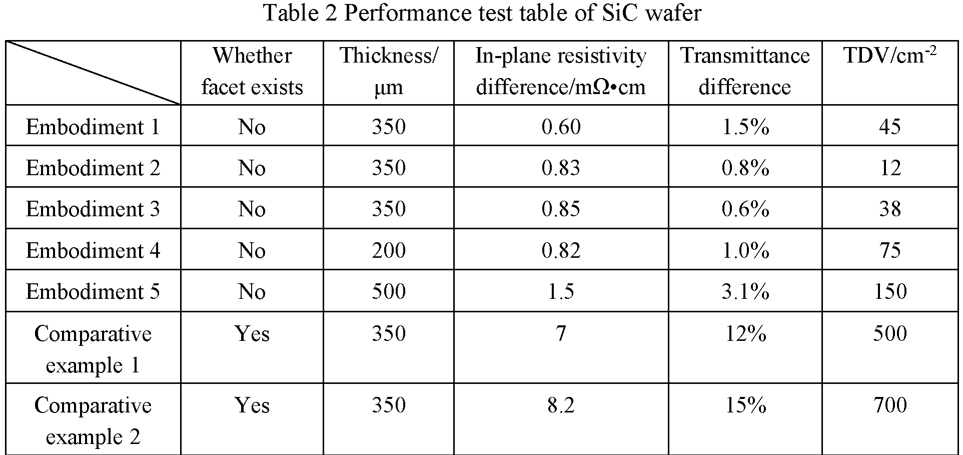

Referring to Table 2, it may be seen that the SiC wafer of the present invention has no macroscopic facet, the in-plane resistivity of the SiC wafer is even, an abnormal low-resistance area does not exist, and the transmittance and TDV are highly even.

On the basis of embodiments 1 to 4, the SiC crystals prepared by embodiments 1 to 4 are directly cut respectively to obtain the SiC wafer with facets in edge area, and a performance test is performed on the obtained silicon carbide wafer containing the facet, referring to Table 3.

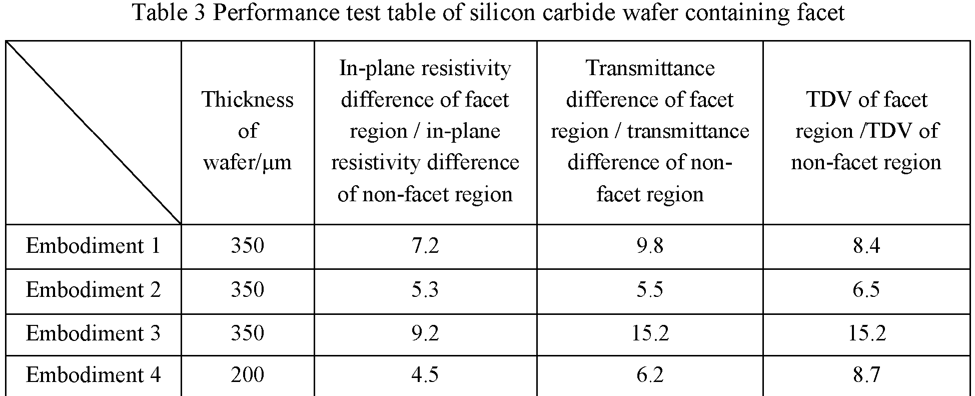

Referring to Table 3, it may be seen that the in-plane resistivity difference containing the facet region is 4 times or above the in-plane resistivity difference of the non-facet region; the transmittance difference of the facet region is 5 times or above the transmittance difference of the non-facet region; and the TDV of the facet region is 6 times or above the TDV of the non-facet region.

According to the present invention, the SiC crystal merely with the facet at the edge is obtained through growth by a PVT method directly and without subsequent processing, the facet region is fixed to the outer circumference of the SiC crystal, the facet region is eliminated in the subsequent crystal processing process, the situation that the entire crystal bar and the wafer and substrate processed accordingly have no facet region is implemented with a low cutting loss rate, the production cost of the silicon carbide crystal is reduced, and meanwhile, it is ensured that the silicon carbide wafer with fewer defects and high evenness is obtained.

### Experimental embodiment 2

The above embodiments and comparative examples both adopt the PVT crystal growth method to prepare the silicon carbide crystal, the embodiments and comparative examples both adopt the same edge cutting (excision for 5 mm), radial cutting, grinding and polishing processes to obtain a silicon carbide substrate, a performance detection is performed on the obtained silicon carbide substrate, and a result is seen in Table 4. A specific test method is as follows:

A Semilab WT-2000 low-resistance tester is adopted for a resistivity, 73 evenly and symmetrically distributed point locations in a silicon carbide substrate sheet are taken for testing, and in the present invention, a mapping diagram is adopted to represent resistivity distribution conditions of the substrate sheet.

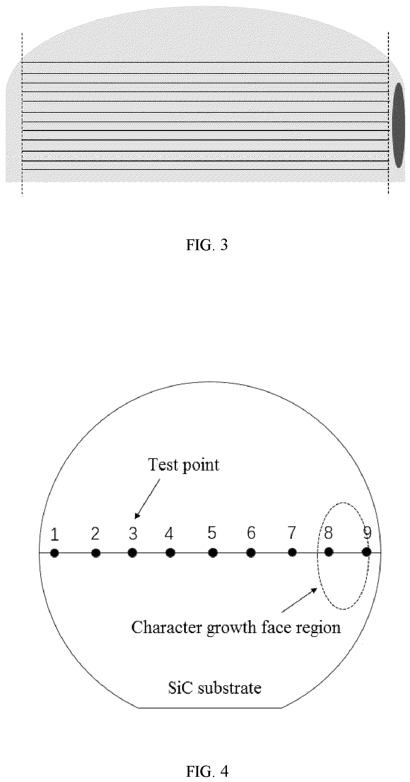

A haze meter CS-700 is adopted for a transmittance, a plurality of points are taken along a diameter of the substrate sheet passing through a center and a growth character face area for testing, and a test method refers to FIG. 4.

Silicon carbide substrates without growth character faces and with different sizes and doping concentrations are prepared through the above method, and a performance test of the silicon carbide substrates without the growth character faces of embodiments 6 to 10 and comparative example 2 refers to Table 4.

An in-plane resistivity difference is "an in-plane resistivity maximum - an in-plane resistivity minimum"; and a transmittance difference is "a transmittance maximum - a transmittance minimum".

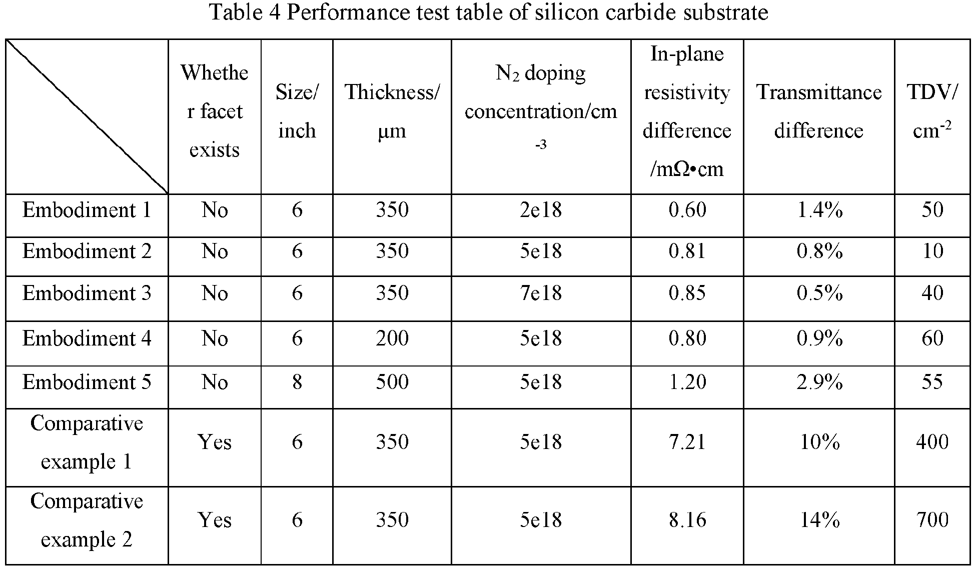

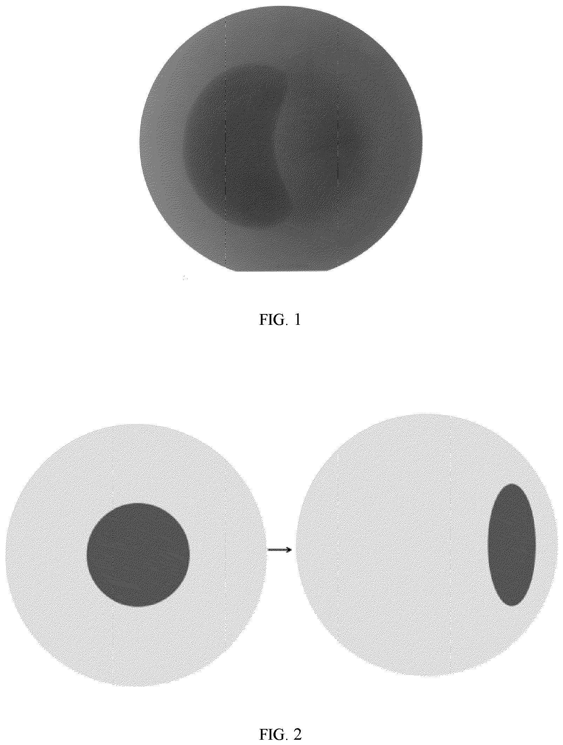

According to the present invention, discontinuous temperature gradient distributions are arranged in a radial direction of a growth face of the crystal to ensure that transverse growth driving force is enough at the edge of the crystal, and the continuous diameter expansion growth ability of the edge of the crystal is ensured. The crystals of the embodiments and the comparative examples are subjected to conventional and same processes of edge cutting, radial cutting, grinding, and polishing and will not change the quality of the substrate. Thus, it may be known according to data of Table 1 that the preparation method of the present invention may control a movement tendency of the growth character face, the growth character face is fixed to the edge of the crystal, and the movement tendency control refers to FIG. 2. Referring to FIG. 3, the growth character face at the edge of the crystal may be eliminated with the cutting of the edge of the crystal, thus, the substrates of embodiments 1 to 5 have no growth character faces, and an existing forward temperature gradient in comparative example 1 and a temperature gradient of - 6°C/mm at an edge in comparative example 2 cannot make the growth character face move to the edge and fixed at the edge.

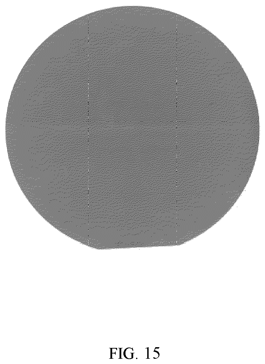

The silicon carbide substrates in comparative example 1 and comparative example 2 both have the macroscopic growth character face, the structure is shown in FIG. 1, and it may be seen that the silicon carbide substrates without the growth character faces do not contain black spots similar to "birthmarks" within the total area range. The silicon carbide substrates prepared in embodiments 1 to 5 do not contain the macroscopic growth character faces, and the structure is shown in FIG. 15. It may be known from the above embodiments, the comparative examples, FIG. 1 and FIG. 15 that the preparation method of the present invention is adopted to obtain the silicon carbide substrate without the growth character face, it may be known in combination with other parameters disclosed in Table 4 that since the structure of the growth character face does not exist, the in-plane resistivity difference of the silicon carbide substrate is less than or equal to 2.0 mΩ•cm, the transmittance difference is less than or equal to 3%, and the TDV is less than 200 cm⁻², representing that the whole performance of the silicon carbide substrate is improved; while the in-plane resistivity difference of the silicon carbide substrate containing the growth character face in comparative example 1 and comparative example 2 is greater than 5 mΩ•cm, the transmittance difference is greater than 10%, and the TDV is greater than 400 cm⁻², representing that the whole performance of the silicon carbide substrate is poor.

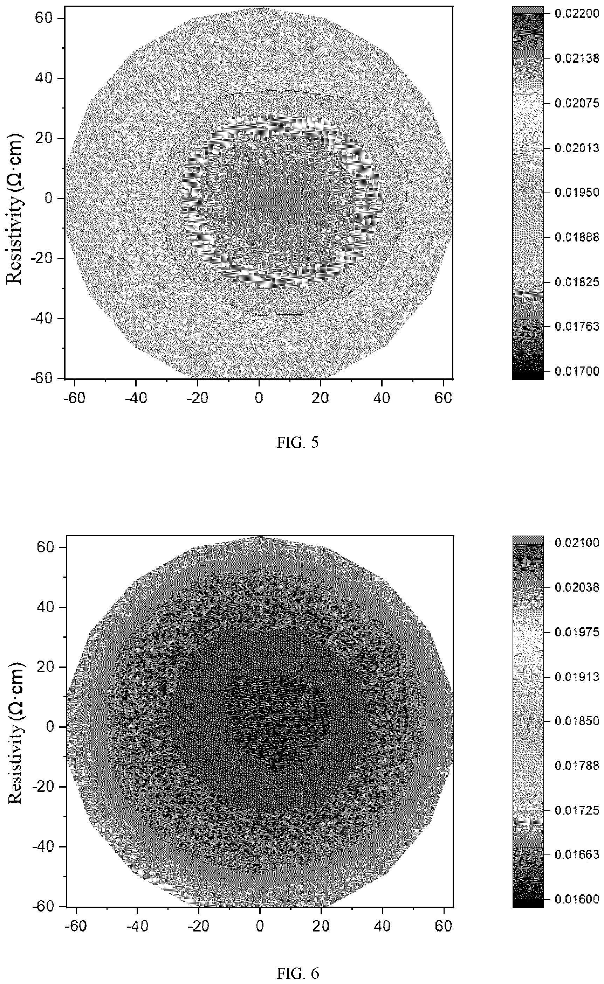

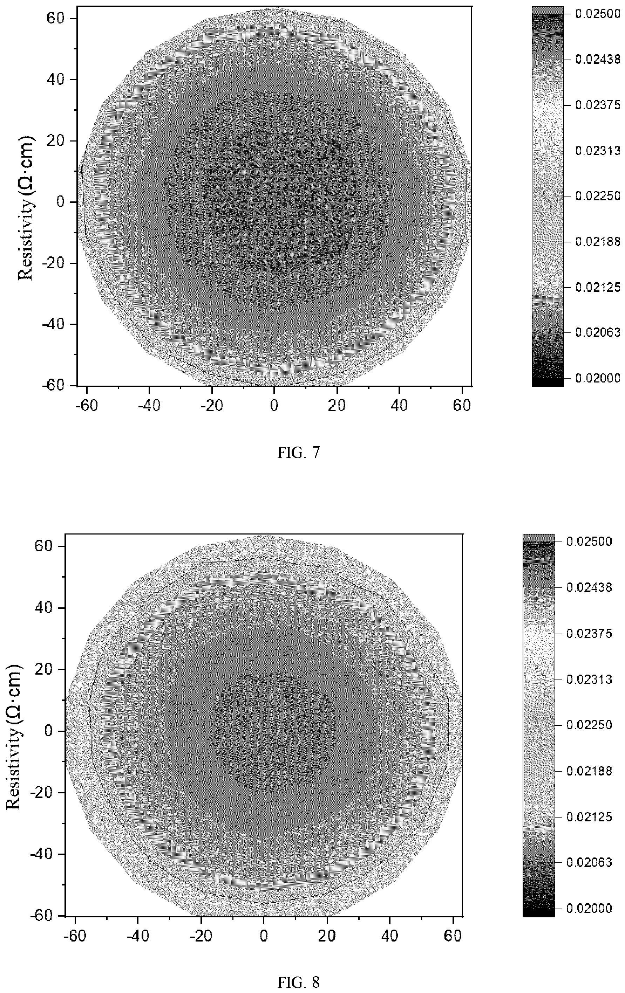

FIG. 5 shows a mapping diagram of a resistivity of a silicon carbide substrate of embodiment 1 of the present invention, FIG. 6 shows a mapping diagram of a resistivity of a silicon carbide substrate of embodiment 2 of the present invention, FIG. 7 shows a mapping diagram of a resistivity of a silicon carbide substrate of embodiment 3 of the present invention, and FIG. 8 shows a mapping diagram of a resistivity of a silicon carbide substrate of embodiment 4 of the present invention. Referring to FIG. 5 to FIG. 8, a horizontal axis represents the diameter of the silicon carbide substrate, a center point of the silicon carbide substrate is a coordinate 00 point, a test area of equipment in the mapping diagram is (-60 mm, 60 mm), a vertical axis represents the resistivity, color changing represents the resistivity distribution conditions, it may be seen that in the present invention, the silicon carbide substrate has even in-plane resistivity distributions, and has no abnormal low-resistance area, and the resistivity in-plane difference is less than 3 mΩ•cm; and in some embodiments, the resistivity in-plane difference is less than 1 mΩ•cm.

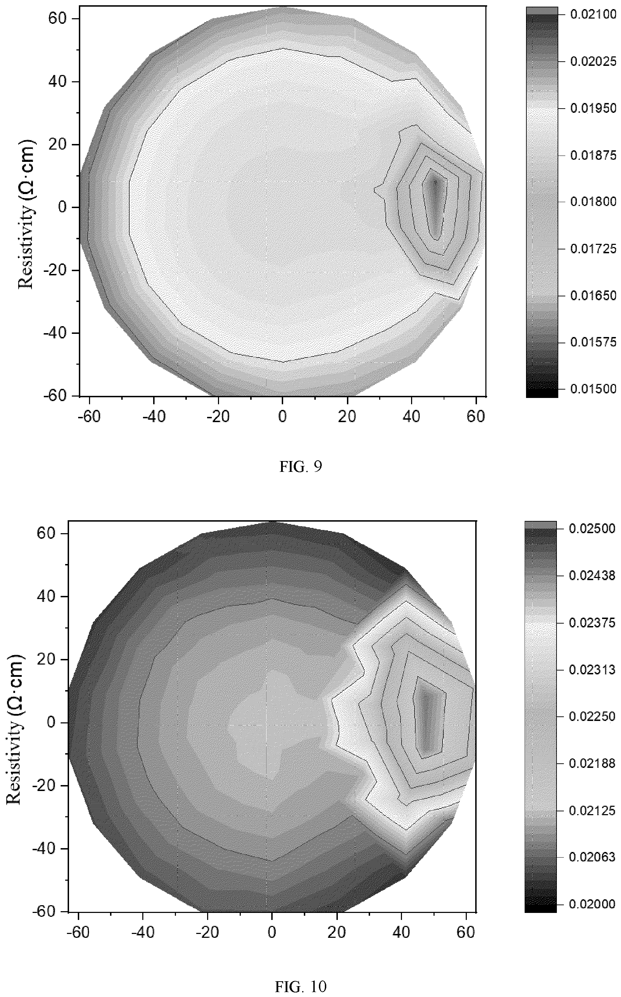

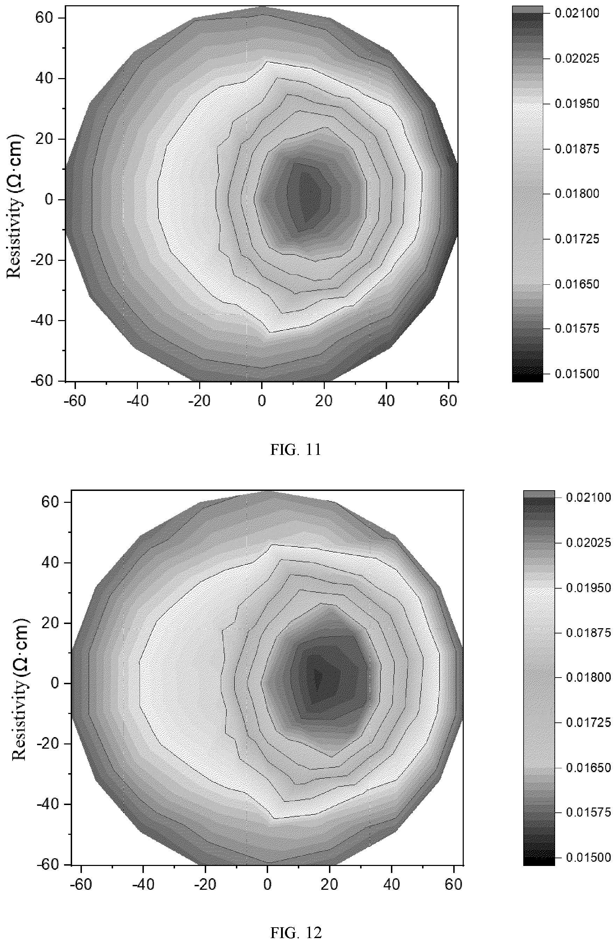

FIG. 9, FIG. 10, FIG. 11 and FIG. 12 respectively show a mapping diagram of a resistivity of a silicon carbide substrate of comparative example 1 of the present invention. An inventor performed four sets of repeated experiments on comparative example 1, referring to FIG. 9, FIG. 10, FIG. 11 and FIG. 12, the center point of the silicon carbide substrate is the coordinate 00 point, the horizontal axis represents that an area of the silicon carbide substrate is tested as (-60 mm, 60 mm), the vertical axis represents the resistivity, it may be seen that since the growth character face exists, apparent low-resistance abnormal areas exist on the resistivity distributions, and the resistivity in-plane difference is generally greater than 5 mΩ•cm.

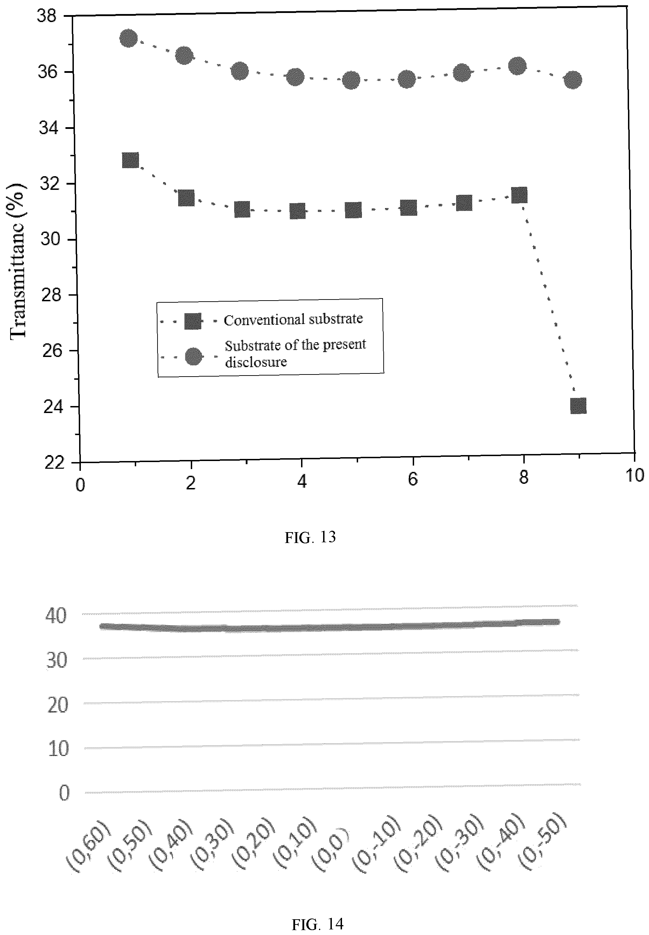

FIG. 13 shows a comparison diagram of transmittances of a silicon carbide substrate of embodiment 2 and a silicon carbide substrate of comparative example 1 of the present invention. In FIG. 13, a horizontal axis represents test counts, and a vertical axis represents the transmittance; and a circle curve is a curve diagram of the transmittance of the silicon carbide substrate of embodiment 2, and a block curve is a curve diagram of the transmittance of the silicon carbide substrate of comparative example 1. It may be seen from FIG. 13 that a visible light transmittance of comparative example 1 at the growth character face area is suddenly descended, which is caused by the absorption of part of visible light bands due to the fact that a doping concentration and a carrier concentration in the growth character face area are much higher than those in other areas. The silicon carbide substrate obtained from embodiment 2 of the present invention eliminates the problems of too high doping concentration and carrier concentration of the growth character face, in-plane impurities and the carrier concentration of the substrate are distributed evenly, and the in-plane transmittance evenness and consistency of the visible light are greatly improved.

FIG. 14 shows a variation curve diagram of a transmittance of a silicon carbide substrate of embodiment 3 of the present invention. A horizontal axis represents different test coordinate points of the silicon carbide substrate, a vertical axis represents the transmittance, and it may be seen from FIG. 14 that in-plane transmittances are distributed evenly.

According to the present invention, since the growth character face is eliminated, the resistivity evenness and the transmittance evenness in the substrate are greatly improved, the aggregations of wrappages or dislocations, micropipes and the like at the growth character face existing in a usual substrate do not exist in the substrate, and the quality and yield of the substrate are greatly improved; and the performance and reliability of the substrate in the subsequent device technology and use process will be greatly improved.

It may be known according to the above analysis that the processing manner of the silicon carbide substrate obtained from embodiments 1 to 5 breaks through a conventional continuous forward radial temperature distribution design, designs a negative radial temperature gradient at the growth edge of the crystal creatively, and drives the growth character face to change the movement tendency, so that the growth character face is fixed to the edge area of the crystal; and in combination with the diameter of the seed crystal being at least 5 mm or above greater than a target diameter, the growth character face is finally fixed into the range 5 mm from the edge of the crystal, and then the crystal is cut, ground, polished and the like to obtain the silicon carbide substrate not containing the growth character face.

Since the elimination of the growth character face has been completed at the crystal growth stage, the subsequent substrate processing technology cannot generate an influence on the above electrical property, and thus, the substrate processing manner is not especially limited by the present invention, and is conventionally operated by those skilled in the art. This growth solution is simple and easy to implement, and may ensure stress and defect control under the continuous and smaller temperature gradient of a center area of the crystal. Through the above innovation, the growth character face may be fixed to the edge position of the crystal and is eliminated in the subsequent crystal processing process, the situation that the entire crystal bar and the substrate processed accordingly have no growth character face is implemented, the objective of eliminating the defect aggregation area is achieved, and the yield and reliability of ends of the devices are ensured.

However, the preparation method of the silicon carbide substrate not containing the growth character face of the present invention includes but is not limited to this. Those skilled in the art may also adopt other manners capable of controlling the growth character face to prepare the silicon carbide substrate, and thus, the preparation method disclosed in the present invention is merely illustrative, and does not constitute limitations on the self-performance of the silicon carbide substrate. Those skilled in the art may also study a new preparation method through an existing technical reserve and creative labors to obtain the silicon carbide substrate of the present invention, and other preparation methods are not within the study range of the present invention, which is not spread for study.

The above descriptions are merely preferred embodiments of the present invention, and are not used to limit the present invention, and for those skilled in the art, the present invention may have various modifications and changes. Any modification, equivalent replacement, improvement and the like made within the spirit and principles of the present invention shall be included in the scope of protection of the present invention.

## Claims

1. A SiC crystal with facets in edge area, wherein the SiC crystal comprises a facet region and a non-facet region; and the facet region is located on an outer circumference of the SiC crystal, a distance between an edge of the facet region away from the outer circumference and the outer circumference does not exceed 3% of a diameter of the SiC crystal, and the SiC crystal is obtained by adopting a PVT method through direct growth without subsequent processing.

2. The SiC crystal according to claim 1, wherein a maximum sectional area of the facet region occupies 10% or below of a cross sectional area of the SiC crystal in a diameter direction; and/or
a volume of the facet region occupies 2% or below of a volume of the entire SiC crystal.

3. The SiC crystal according to claim 2, wherein the maximum sectional area of the facet region occupies 5% or below of the cross sectional area of the SiC crystal in the diameter direction; and/or
the volume of the facet region occupies 0.6% or below of the volume of the entire SiC crystal.

4. The SiC crystal according to claim 1, wherein an in-plane resistivity difference of the facet region is 5 times or above an in-plane resistivity difference of the non-facet region; and/or
a transmittance difference of the facet region is 5 times or above a transmittance difference of the non-facet region; and/or
a TDV of the facet region is 6 times or above a TDV of the non-facet region.

5. The SiC crystal according to claim 4, wherein the in-plane resistivity difference of the facet region is 8 times or above the in-plane resistivity difference of the non-facet region; and/or
the transmittance difference of the facet region is 14 times or above the transmittance difference of the non-facet region; and/or
the TDV of the facet region is 10 times or above the TDV of the non-facet region.

6. A facet-free silicon carbide crystal bar, wherein the facet-free silicon carbide crystal bar is obtained by removing the facet region from the SiC crystal with facets in edge area according to any one of claims 1 to 5.

7. A high-quality silicon carbide substrate, wherein the high-quality silicon carbide substrate is obtained by processing the SiC crystal with facets in edge area according to any one of claims 1 to 5, the silicon carbide substrate is of a conductive type, and the whole area does not contain any one or two or more of the following: a growth character face, a highly-doped area, a defect aggregation area; and the silicon carbide substrate is prepared by adopting the PVT method.

8. The high-quality silicon carbide substrate according to claim 7, wherein when the silicon carbide substrate is an N-type element doping and an N-type element doping concentration is greater than 1e¹⁸cm⁻³, the whole area of the high-quality silicon carbide substrate meets the following condition:
a, an in-plane resistivity difference is less than or equal to 2.0 mΩ•cm;
b, a transmittance difference is less than or equal to than 3%.

9. The high-quality silicon carbide substrate according to claim 8, wherein the in-plane resistivity difference is less than or equal to 1.0 mΩ•cm.

10. The high-quality silicon carbide substrate according to claim 9, wherein when the N-type element doping concentration is 2e^{18 ~} 7e¹⁸cm⁻³, the in-plane resistivity difference is 0.62-0.86mΩ•cm.

11. The high-quality silicon carbide substrate according to claim 8, wherein the transmittance difference ranges from 0.5% to 1.6%.

12. The high-quality silicon carbide substrate according to claim 8, wherein the N-type element doping is N₂ doping, and the in-plane resistivity difference is 0.62-0.86 mΩ•cm; and the transmittance difference ranges from 0.5% to 1.6%.

13. The high-quality silicon carbide substrate according to claim 8, wherein a TDV of the silicon carbide substrate is less than 200 cm⁻².

14. The high-quality silicon carbide substrate according to claim 13, wherein the TDV of the silicon carbide substrate is less than 100 cm⁻².

15. The high-quality silicon carbide substrate according to claim 7, wherein a size of the silicon carbide substrate is 6 inches, 8 inches, 10 inches, or 12 inches.

16. A semiconductor device, comprising the high-quality silicon carbide substrate according to claim 7.
